# EUROPEAN PATENT APPLICATION

(11) **EP 1 453 195 A2**
(43) Date of publication of application: **01.09.2004**
(21) Application number: 04004359.8
(22) Date of filing: 26.02.2004
(51) Int. Cl.: H03G 3/34

(54) **AGC circuit**

(30) Priority: 27.02.2003 JP 2003050377
(71) Applicant: Alps Electric Co., Ltd., Tokyo 145-8501 (JP)
(72) Inventor: Shibata, Etsuya, Ota-ku Tokyo 145-8501 (JP)
(74) Representative: Klunker . Schmitt-Nilson . Hirsch

(57) **Abstract**

Binary data from a comparison circuit and external binary data, which are input externally, are input to a reference voltage generation circuit. When a high-frequency signal is at a level less than or equal to a predetermined level, the reference voltage is made to drop to a grounding potential, and the variable gain means is placed in a maximum attenuation state. In the range where the high-frequency signal is at a level higher than or equal to the predetermined level, the reference voltage is switched to a level other than the grounding potential in accordance with the external binary data, and the level of the high-frequency signal output from the variable gain means is set.

## Description

### BACKGROUND OF THE INVENTION

### 1. Field of the Invention

The present invention relates to an AGC circuit used in a television signal transmitter, etc.

### 2. Description of the Related Art

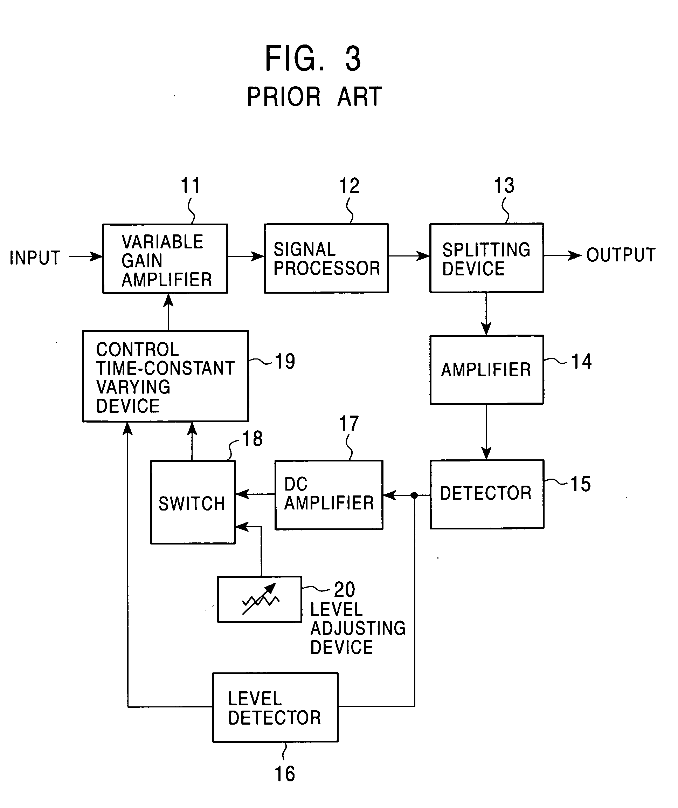

A conventional AGC circuit will now be described with reference to Fig. 3. A variable gain amplifier 11 amplifies an input high-frequency signal at a gain corresponding to an external DC signal level from a control input end. The output of the variable gain amplifier 11 is supplied to a signal processor 12, where the output undergoes processing, such as reception processing, intermediate frequency conversion, and power amplification. A part of a power amplification signal output from the signal processor 12 is split by a splitting device 13 and is guided to an antenna system (not shown).

The signal split by the splitting device 13 is amplified by an amplifier 14 and is guided to a detector 15. The detector 15 detects, from the input signal, a DC output level signal corresponding to an output power level. This detected output is supplied to a level detector 16 and a DC amplifier 17.

The level detector 16 has a function for detecting "signal present" at, for example, a rated level of -15 dB in order to detect "signal present", and a function for detecting the upper limit and the lower limit of the output at, for example, a rated level of ±2 dB. The DC amplifier 17 DC-amplifies the detected output and outputs it to a switch 18.

This switch 18 selectively switches between the DC output of the DC amplifier 17 and the DC output of a reference DC level adjusting device 20 in accordance with a signal presence or absence detection output signal of the level detector 16, and guides out the DC output. The guided DC output is supplied to a control time-constant varying device 19.

The control time-constant varying device 19 causes, in accordance with a control signal from the level detector 16, the time constant to be changed from an instantaneous operation up to a rated delay in the case where the level is outside the output level range, and causes the time constant to be changed from a minimum delay up to the rated delay in the case where the level is within the output level range, and using this time constant, the DC input from the switch 18 is supplied as a gain control signal to the variable gain amplifier 11.

In the level detector 16, detection of whether the output signal is off and detection of whether the output signal level is outside the set range are performed. In the switch 18, when it is detected that the output is off, switching to a fixed gain bias is made. The control time-constant varying device 19 functions so that the time constant is made variable from the minimum value (0) up to a value which is required at rating time, and by making all the other time constants within the loop minimum values, a high-speed operation is performed.

In the above-described configuration, since switching to a fixed gain bias is made when there is no input signal, a high-frequency signal line is at a normal rated gain. The circuit time constant of the AGC loop is set for high-speed operation. When a rated input signal is applied, the output signal is output at nearly the rated level, output detection is performed to switch to the AGC loop side, the AGC time constant increases gradually, and low-speed operation is performed. For this reason, an output signal which nearly corresponds to the input signal level is obtained, and the transient characteristics become satisfactory.

When the input signal is high, output detection, AGC loop switching, stabilization of a high-speed operation level, and the detection of the output range are performed in sequence, and low-speed operation is performed gradually. The same applies to the case where the input signal is low, and the level stabilizes at high speed without exceeding the rated output.

When the input signal changes sharply, the fact that the output level becomes out of range is detected, switching to high-speed operation is made, the high-speed level is stabilized, the fact that the level is within the output range is detected, and the operation gradually shifts to low-speed operation (for example, refer to Japanese Unexamined Utility Model Registration Application Publication No. 6-54312).

In the above-described configuration, a time constant variable circuit is provided within the AGC loop, and a sharp change of the input signal level (or including when the state changes from a state with no signal to a state with a signal) is detected to cause the time constant to be gradually changed from the minimum value to a normal value, thereby suppressing overshooting of the output level. However, a problem arises in that the configuration of the time constant variable circuit becomes extremely complex.

### SUMMARY OF THE INVENTION

An object of the present invention is to easily suppress overshooting of the output signal level, which occurs when the input signal changes sharply, and to be capable of easily setting the output signal level at an AGC controlled state.

To achieve the above-mentioned object, the present invention provides an AGC circuit including: variable gain means for amplifying or attenuating an input high-frequency signal in accordance with the level of a gain control voltage; detection means for detecting a high-frequency signal which is split from splitting means provided at a stage after the variable gain means and for outputting a DC voltage; a differential amplifier for comparing the DC voltage with a reference voltage in order to generate the gain control voltage; a reference voltage generation circuit for generating the reference voltage; and a comparison circuit for outputting binary data by determining whether the high-frequency signal input to the variable gain means is at a level lower than or equal to, or at a level higher than or equal to a predetermined level, wherein the binary data and external binary data which is externally input are input to the reference voltage generation circuit; when the high-frequency signal is at a level lower than or equal to the predetermined level, the reference voltage is made to drop to a grounding potential, and also, the variable gain means is placed in a maximum attenuated state; and in the range where the high-frequency signal is at a level higher than or equal to the predetermined level, by switching the reference voltage to a level other than the grounding potential in accordance with the external binary data, the level of the high-frequency signal output from the variable gain means is set. As a result, a high-frequency signal is not input to the variable gain means until that time. When a high-frequency signal at a level higher than or equal to the predetermined level at a particular moment, the variable gain means is placed in a maximum attenuation state until it rises to the predetermined level, and at the stage where the high-frequency signal is increased thereafter, the reference voltage is switched to a level other than the grounding potential in accordance with the external binary data, and overshooting of the high-frequency signal level output from the variable gain means is reduced. Furthermore, the output level at an AGC-controlled state in which a reference voltage other than the grounding potential is applied can be set at an appropriate level depending on the TV transmission system used.

The reference voltage generation circuit may include two or more AND circuits for computing the logical AND of binary data output from the comparison circuit and the external binary data; a decoder controlled by the AND circuit; and voltage-dividing circuits which are independently connected to a plurality of output ends of the decoder, wherein a voltage output from the voltage-dividing circuit is assumed to be the reference voltage. Therefore, a plurality of reference voltages, including a grounding potential, can be generated.

The variable gain means may be formed of a variable attenuator using a pin diode, and an amplifier may be connected at the next stage of the variable attenuator. Therefore, impedance matching during attenuation can be obtained.

### BRIEF DESCRIPTION OF THE DRAWINGS

Fig. 1 is a circuit diagram showing the configuration of an AGC circuit of the present invention;
Fig. 2 is a circuit diagram showing the configuration of a reference voltage generation circuit used in the AGC circuit of the present invention; and
Fig. 3 is a circuit diagram showing the configuration of a conventional AGC circuit.

### DESCRIPTION OF THE PREFERRED EMBODIMENT

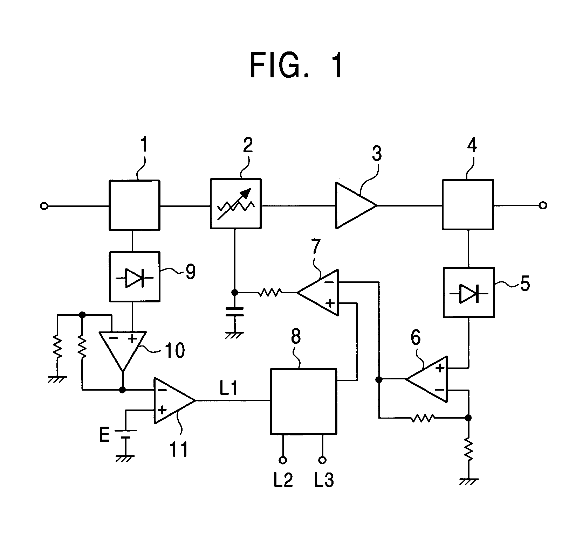

An AGC circuit of the present invention will now be described with reference to the configuration shown in Fig. 1. A high-frequency signal is input to variable gain means 2 via second splitting means 1. The variable gain means 2 is formed of a variable attenuator, such as, for example, a pin diode variable attenuator (pin attenuator), but it is sometimes formed of a variable gain amplifier. For the variable gain means 2, attenuation or gain is controlled depending on a gain control voltage. At the next stage of the variable gain means 2, an amplifier 3 whose gain is fixed is connected, and first splitting means 4 is connected at the stage after the amplifier 3.

A high-frequency signal split from the first splitting means 4 is input to first detection means 5. The first detection means 5, formed of a normal detector, detects a high-frequency signal and outputs a first DC voltage. The first DC voltage is DC-amplified by a first amplifier 6. The first amplified DC voltage is input to one of the input ends (for example, an inverting input end -) of a differential amplifier 7. A reference voltage is applied from a reference voltage generation circuit 8 to the other input end (a non-inverting input end +) of the differential amplifier 7.

According to the above configuration, if the level of the high-frequency signal input to the variable gain means 2 becomes high, the first DC voltage input to the differential amplifier 7 increases, and the gain control voltage, which is an output therefrom, drops. Therefore, if the variable gain means 2 is suited to a forward AGC circuit (the gain increases when the gain control voltage increases), the variable gain means 2 operates in the direction in which the gain attenuates, and the output level thereof becomes constant. The constant output level is set by the level of the reference voltage (supplied from the reference voltage generation circuit 8) applied to the differential amplifier 7.

On the other hand, a part of the high-frequency signal input to the variable gain means 2 is split by the second splitting means 1 and is input to second detection means 9. The second detection means 9, which is configured in the same way as the first detection means 5, detects a high-frequency signal and inputs a second DC voltage to a second operational amplifier 10. The second operational amplifier 10 is configured in the same way as the first amplifier 6. The second DC voltage is DC-amplified by the second operational amplifier 10 and is input to one of the input ends (for example, an inverting input end -) of a comparison circuit 11. A fixed reference voltage E is applied to the other input end (a non-inverting input end +) of the comparison circuit 11.

The comparison circuit 11 outputs binary data L1 of logic level 1 or 0 by comparing the second DC voltage input to the inverting input end (-) with the fixed reference voltage E input to the non-inverting input end (+). In this configuration, if the second DC voltage becomes lower than the reference voltage E, the logic level 0 is output. Accordingly, the reference voltage E is set in such a manner that the logic level 0 is output when the level of the high-frequency signal input to the variable gain means 2 is less than or equal to a predetermined value (for example, -10 dBm). The binary data L1 output from the comparison circuit 11 is input to the first reference voltage generation circuit 8.

The reference voltage generation circuit 8 has a function for switching the level of the reference voltage applied to the differential amplifier 7 in accordance with the binary data L1 input from the comparison circuit 11. When the logic level is 0, the reference voltage is unconditionally made to be a grounding potential of a minimum value (almost 0 volts), and when the logic level is 1, one of three kinds of reference voltages having different levels other than the grounding potential is selected on the basis of binary data L2 and L3, which are input externally.

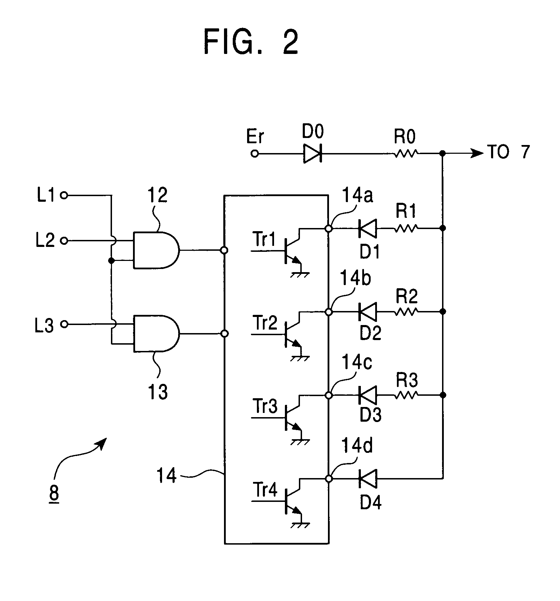

The configuration of the reference voltage generation circuit 8 is shown in Fig. 2. The binary data L1 from the comparison circuit 11 is input to one of the input ends of each of the two AND circuits 12 and 13. Furthermore, the binary data L2 and L3 (logic level 1 or 0) are externally input independently to the other input end of the AND circuit 12 and the other input end of the AND circuit 13. A decoder 14 (2 to 4 decoder) is connected to the output ends of the two AND circuits 12 and 13. At the output stage within the decoder 14, transistors Tr1 to Tr14 whose collectors are connected to output terminals 14a to 14d are provided, respectively. When the number of AND circuits is to be increased, the configuration of the decoder 14 is changed accordingly.

Furthermore, reverse-current preventing diodes D1 to D4 are connected to the output terminals 14a to 14d, respectively, and resistors R1 to R3 whose resistances differ from each other are connected in series to the diodes D1 to D3 among the diodes D1 to D4. Both the resistors R1 to R3 and the diode D4 are connected to a power-supply resistor R0, with a voltage Er being supplied to the power-supply resistor R0 via the diode D0. Each combination of the power-supply resistor R0 and the resistors R1 to R3 constitutes a voltage-dividing circuit. Then, the connection point of the power-supply resistor R0, and the other resistors R1 to R3 and the diode D4 is connected to the non-inverting input end (+) of the differential amplifier 7.

In the above-described configuration of Fig. 2, when the binary data L1 is 0 or when both the two binary data L2 and L3 are 0, the transistor Tr4 is turned on. Therefore, the reference voltage applied to the differential amplifier 7 becomes almost 0 volts, and the gain control voltage output from the differential amplifier 7 becomes almost 0 volts regardless of the magnitude of the first DC voltage input to the inverting input end (-). Therefore, the variable gain means 2 is placed in a maximum attenuation state in the range where the input high-frequency signal is lower than or equal to a predetermined level.

When the binary data L1 is 1 and at least one of the binary data L2 and L3 is 1, one of the transistors Tr1 to Tr3 is turned on. Therefore, in this case, the voltage divided by the power-supply resistor R0 and one of the resistors R1 to R3 is applied as a reference voltage to the non-inverting input end (+) of the differential amplifier 7. Therefore, since a voltage is applied in the state in which there is no high-frequency signal input to the variable gain means 2, the voltage is increased, and in the stage where a predetermined level is exceeded, the first DC voltage has already been input to the inverting input end (-) of the differential amplifier 7, the difference with respect to the reference voltage is small, and the gain control voltage is applied to the variable gain means 2 so that the DC voltage increases from the maximum attenuation state. As a result, the state has escaped from the maximum attenuation state, and the output level does not become exceedingly large. Then, the output level becomes constant at an output level determined by the reference voltage. The constant output level varies depending on the resistors R1 to R3 and is set on the basis of the binary data L2 and L3.

In the present invention, since a plurality of kinds of reference voltages to be supplied to the differential amplifier 7 can be set, there are advantages that, not only can excessive overshooting of the output level be suppressed when a high-frequency signal is input, but also the output level in an AGC-controlled state can be set at an appropriate level depending on the TV transmission system used.

## Claims

1. An AGC circuit comprising:
variable gain means for amplifying or attenuating an input high-frequency signal in accordance with the level of a gain control voltage;
detection means for detecting a high-frequency signal which is split from splitting means provided at a stage after said variable gain means and for outputting a DC voltage;
a differential amplifier for comparing said DC voltage with a reference voltage in order to generate said gain control voltage;
a reference voltage generation circuit for generating said reference voltage; and
a comparison circuit for outputting binary data by determining whether said high-frequency signal input to said variable gain means is at a level lower than or equal to, or at a level higher than or equal to a predetermined level,
wherein said binary data and external binary data which is externally input are input to said reference voltage generation circuit; when said high-frequency signal is at a level lower than or equal to said predetermined level, said reference voltage is made to drop to a grounding potential, and also, said variable gain means is placed in a maximum attenuated state; and in the range where said high-frequency signal is at a level higher than or equal to said predetermined level, by switching said reference voltage to a level other than said grounding potential in accordance with said external binary data, the level of the high-frequency signal output from said variable gain means is set.

2. An AGC circuit according to Claim 1, wherein said reference voltage generation circuit comprises:
two or more AND circuits for computing the logical AND of binary data output from said comparison circuit and said external binary data;
a decoder controlled by said AND circuit; and
voltage-dividing circuits which are independently connected to a plurality of output ends of said decoder, wherein a voltage output from said voltage-dividing circuit is assumed to be said reference voltage.

3. An AGC circuit according to one of Claims 1 and 2, wherein said variable gain means is formed of a variable attenuator using a pin diode, and an amplifier is connected at the next stage of said variable attenuator.
